# EUROPEAN PATENT SPECIFICATION

(11) **EP 0 470 632 B1**
(45) Date of publication and mention of the grant of the patent: **02.10.1996**
(21) Application number: 91113378.3
(22) Date of filing: 09.08.1991
(51) Int. Cl.: H01L 21/316

(54) **Method of manufacturing a silicon oxide film and an oxide based glass for semiconductor devices**
Verfahren zum Herstellen eines Siliciumoxidfilms und eines Oxid enthaltenden Glasfilms für Halbleiteranordnungen
Procédé pour fabriquer un film d'oxyde de silicium et un film de verre contenant un oxyde pour des dispositifs semi-conducteurs

(30) Priority: 10.08.1990 JP 213343/90
(43) Date of publication of application: 12.02.1992
(73) Proprietor: SEMICONDUCTOR PROCESS LABORATORY CO., LTD., Minato-ku, Tokyo 108 (JP); ALCAN- TECH CO., INC., Tokyo (JP); CANON SALES CO., INC., Minato-ku, Tokyo 108 (JP)
(72) Inventor: Maeda, Kazuo, c/o Semiconductor Process, Minato-ku, Tokyo (JP); Tokumasu, Noboru, c/o Semiconductor Process, Minato-ku, Tokyo (JP); Nishimoto, Yuko, c/o Semiconductor Process, Minato-ku, Tokyo (JP)
(74) Representative: Schwabe - Sandmair - Marx

(56) References cited:
- EP-A- 0 421 203
- EP-A- 0 436 185
- US-A- 4 845 054

## Description

The present invention relates to a manufacturing method for a semiconductor device, and more particularly to a manufacturing method for a semiconductor device for forming a silicon oxide film and a PSG film, a BSG film, or a BPSG film and the like by mixing organic silane and ozone, or gas containing an impurity such as phosphorus and boron.

The inventors of the present application have already found see for example, EP 0 436 185 A1, that a SiO₂ film formed by a TEOS-O₃ reaction has such advantages that step coverage is excellent and that very few particles are generated during film formation, and have also found that characteristics of the film depend on the O₃ concentration, and the following characteristics are obtainable as the O₃ concentration gets higher.
- ①: Increase of film forming speed
- ②: Increase of film density
- ③: Reduction of etching rate
- ④: Reduction of leakage current
- ⑤: Reduction of -OH, H₂O components in a film
- ⑥: Improvement of crack resistance
- ⑦: Reduction of stress
- ⑧: Improvement of step coverage

### (Flow configuration)

On the other hand, however, the TEOS-O₃ reaction being a surface reaction, the reaction is very sensitive to a substrate surface on which the film is accumulated, and the characteristics of formed films are different sometimes when substrate films are different.

A similar process is known from US-A-484 505.

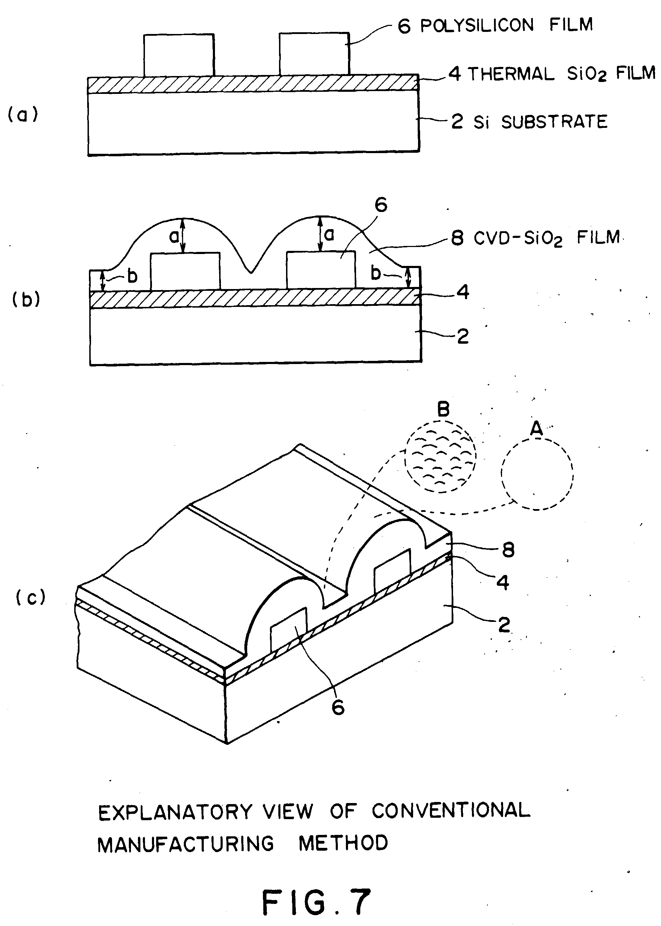

Fig. 7 shows a forming method of a CVD-SiO₂ film by Tetra-Ethyl-Ortho-Silicate (TEOS , Si(OC₂H₅)₄)-O₃ reaction according to a conventional exemplification for explaining the foregoing.

In Fig. 7 (a), a reference numeral 4 denotes a thermal SiO₂ film formed on a surface of a Si substrate 2, and 6 denotes a polycrystalline silicon film (hereinafter referred to in brief as a "poly-Si film") formed on the thermal SiO₂ film 4. Examples of semiconductor devices having such a structure include a MOS transistor comprising the thermal SiO₂ film 4 as a gate SiO₂ film and the poly-Si film 6 as a gate electrode for instance.

Next, a CVD-SiO₂ film 8 is formed as an interlayer insulating film by the TEOS-O₃ reaction as shown in Fig. 7 (b).

Hereupon, it has been found that the surface of the CVD-SiO₂ film 8 accumulated by the TEOS-O₃ reaction is even (see the partially enlarged view A) in case the film 8 is formed on the poly-Si film 6 as shown in a perspective view of Fig. 7 (c), but that unevenness is produced on the film surface sometimes (see the partially enlarged view B) in case the film 8 is formed on the thermal SiO₂ film 4.

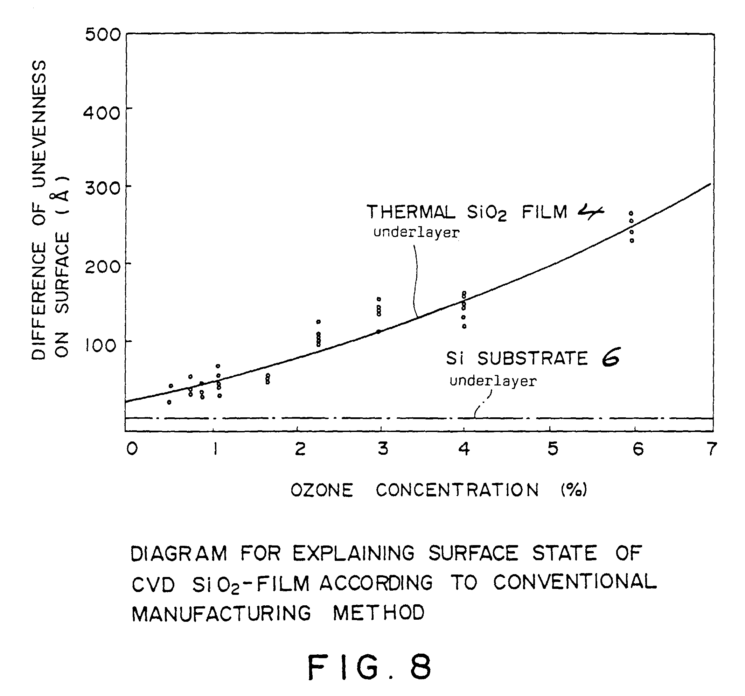

Fig. 8 is a diagram showing measurement results of the unevenness on the surface of the CVD-SiO₂ film formed using such a conventional method by the present inventors. In Fig. 8, the abscissas shows the ozone concentration (%), the ordinate shows the difference in unevenness on the surface of the CVD-SiO₂ film (Å), and parameters are the underlayers (thermal SiO₂ film 4, Si film 6). In such a manner, an even CVD-SiO₂ film surface is obtainable regardless of the O₃ concentration in case the underlayer is of Si 6, but the film surface depends on the O₃ concentration when the underlayer is of the thermal SiO₂ film 4, and there is such a tendency that the unevenness on the CVD-SiO₂ film surface becomes more intense as the O₃ concentration gets higher.

Besides, the unevenness was measured by applying a probe to the surface of the accumulated SiO₂ film and measuring the distance of a vertical movement thereof.

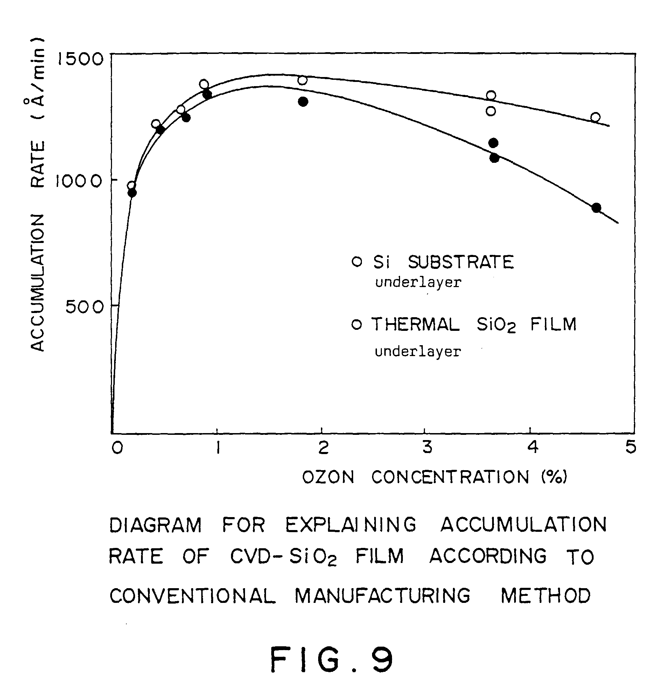

Next, Fig. 9 is a diagram showing the result of measurement of an accumulation rate of the CVD-SiO₂ film formed by a conventional method same as that used in Fig. 8. As shown in the Figure, control is easy in point of manufacturing since dependency of the accumulation rate on the O₃ concentration is small when the O₃ concentration reaches approximately 1% and higher in case the underlayer is of Si 6, but the accumulation rate depends greatly on the O₃ concentration when the underlayer is of a SiO₂ film, and the accumulation rate is lowered as the O₃ concentration gets higher. Thus, there is such a problem that difficulty in manufacturing such as regulating a film thickness is found.

Then, when the O₃ concentration is lowered (approximately 3% and lower), the film quality of the CVD-SiO₂ film is not sufficient, and the step coverage at a step portion changes from a flow configuration to an isotropy, which, therefore, shows a difficult point when the CVD-SiO₂ film is used as an interlayer insulating film.

As described, a conventional method has such a dilemma therewithin that the film quality is good but subject to a serious influence of the underlayer when the O₃ concentration is high. On the other hand, however, the film quality is difficult to be affected by the underlayer but the film quality is deteriorated when the O₃ concentration is low. Thus, it is difficult to solve all the problems at the same time by setting a specific O₃ concentration.

It is an object of the present invention to overcom the problems in such a conventional method and to provide a manufacturing method for a semiconductor device comprising a CVD film such as a SiO₂ film and a BPSG film in which the generation of unevenness on the film surface is controlled and a CVD film such as a SiO₂ film and a BPSG film which has a stabilized accumulation rate, is suitable for flattening, and has a good film quality is formed.

The manufacturing method for a semiconductor device of the present invention solving this object is characterized by the features of claim 1.

When the inventors of the present application had perceived the fact that the characteristic of an accumulated film depends on the surface state of the substrate since the organic silane (such as TEOS)-O₃ reaction is a surface reaction, they have tried various methods as surface processing, and it was found that plasma processing was the best.

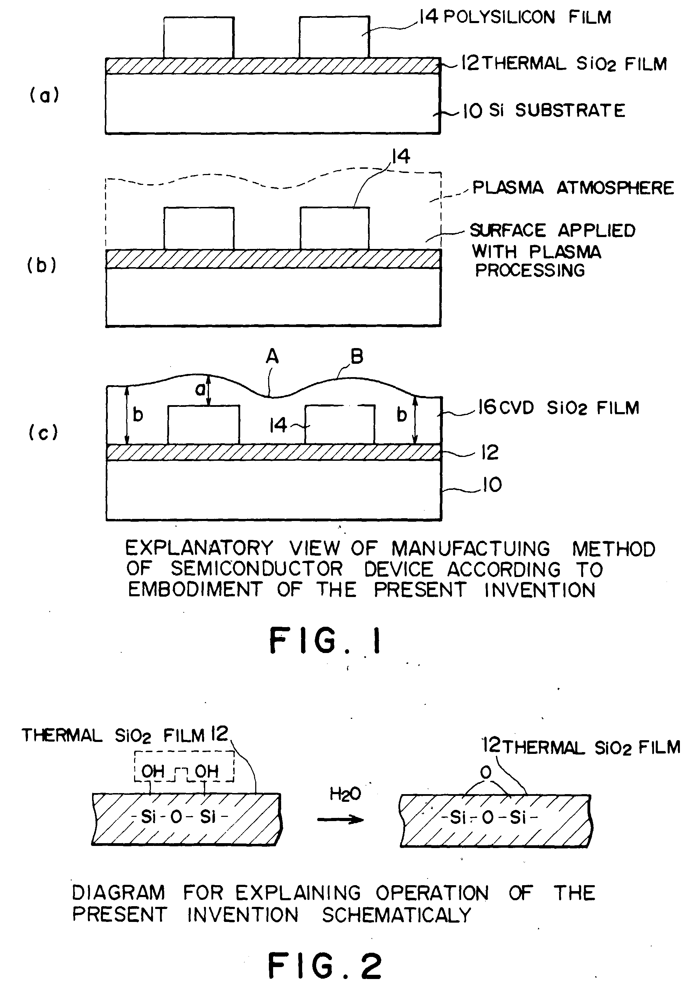

For example, when organic silane (TEOS) and ozone O₃ are mixed with each other and a silicon oxide film (CVD-SiO₂ film 16) is formed on a substrate under atmospheric pressure or reduced pressure after reforming the surface of the substrate (thermal SiO₂ film 12) (Fig. 1 (b)) by applying high frequency plasma irradiation processing in a state that the substrate (a Si substrate 10) is heated as illustrated in Fig. 1, the film thickness b of the SiO₂ film accumulated on the thermal SiO₂ film 12 becomes equal to the film thickness a of the SiO₂ film accumulated on the poly-Si film 12 (a = b), and the unevenness on the surface also disappears, thus solving the conventional problems.

This phenomenon is conjectured to have occurred due to the fact that the surface of the thermal SiO₂ film 12 has been reformed from a hydrophilic property to a hydrophobic property by plasma irradiation processing. Fig. 2 shows this phenomenon schematically. Namely, the surface of the thermal SiO₂ film has a hydrophilic property before plasma processing because of the existence of -OH radical, but it is conjectured that the surface has been reformed as shown in the Figure because of the fact that the Si-OH coupling is broken by means of plasma processing. It can be confirmed practically that the hydrophilic property has been changed to the hydrophobic property by measuring and comparing a contact angle of water at the surface of the thermal SiO₂ film before and after plasma processing.

Besides, a high frequency used in plasma processing is at 13.56 MHz in general, but may be at 100 to 200 KHz. However, since surface reformation is the object, it is required to set the amplitude of electric power to such an extent that is not attended with film formation and etching of the substrate.

Further, activating gas of Ar or He system, N₂ or O₂ is appropriate for the use gas.

Furthermore, the present invention is applicable not only to a case in which the combination of the underlayer illustrated in Fig. 1 is a poly-Si film, but also to cases of the following combinations of the underlayers.
Aℓ-BPSG, PSG, thermal SiO₂
W-BPSG, PSG, thermal SiO₂
WSiₓ-BPSG, PSG, thermal SiO₂
Aℓ-BPSG, PSG, thermal SiO₂
Poly-Si-BPSG, PSG, thermal SiO₂

### BRIEF DESCRIPTION OF THE DRAWINGS

Fig. 1 shows explanatory drawings of a manufacturing method of a semiconductor device according to an embodiment of the present invention;
Fig. 2 is a diagram for explaining the operation of the present invention;
Fig. 3 shows schematic block diagrams of plasma surface processing apparatus according to embodiments of the present invention;
Fig. 4 is a schematic block diagram of a CVD film forming apparatus according to an embodiment of the present invention;
Fig. 5 is a diagram for explaining an accumulation rate of a CVD-SiO₂ film according to a manufacturing method of the present invention;
Fig. 6 is a diagram for explaining a surface state of a CVD-SiO₂ film according to a manufacturing method of the present invention;
Fig. 7 shows explanatory drawings of a conventional manufacturing method;
Fig. 8 is a diagram for explaining a surface state of a CVD-SiO₂ film according to a conventional manufacturing method; and
Fig. 9 is a diagram for explaining an accumulation rate of a CVD-SiO₂ film according to a conventional manufacturing method of the present invention.

In the next place, embodiments and experimental examples of the present invention will be described with reference to the drawings.

### (1) Description of an embodiment of the present invention

### ① The first process

Fig. 1 shows drawings for explaining a forming method of a SiO₂ film by a CVD method of the TEOS-O₃ reaction according to an embodiment of the present invention, in which a numeral 12 denotes a thermal SiO₂ film formed on a surface of a Si substrate 10 by means of thermal processing, and 14 denotes a poly-Si film formed on above-mentioned thermal SiO₂ film 12. For example, a MOS transistor including a thermal SiO₂ film 12 as a gate SiO₂ film and a poly-Si film 14 as a gate electrode has such a structure as described above.

### ② The second process

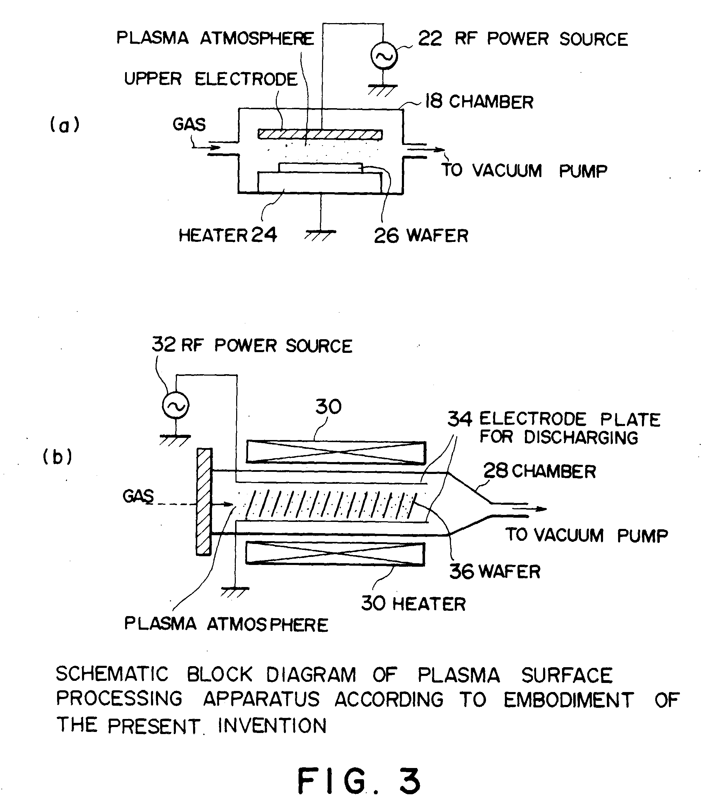

Next, when the Si substrate 10 is placed in a plasma surface processing apparatus shown in Fig. 3 (a) and exposed in a plasma atmosphere of N₂ gas, the Si-OH coupling on the surface of the thermal SiO₂ film 12 is broken and the surface is reformed (see Fig. 1 (b)) as shown in a schematic diagram of Fig. 2.

An RF plasma apparatus of a parallel plate anode coupling system shown in Fig. 3 (a) for instance is used for the plasma processing.

In Fig. 3 (a), 18 denotes a chamber, 20 denotes an upper electrode supplied with high frequency electric power from an RF power source 22, and 24 denotes a heater which heats a wafer 26.

When plasma processing is performed, the wafer 26 is placed on a susceptor (heater 24) in the chamber 18 and heated to approximately 350° for instance, and then N₂ gas is introduced therein, and high frequency electric power at 200 W and 13.56 MHz is applied to the upper electrode 20, thereby to bring N₂ gas into a plasma state. Approximately one minute will suffice for the processing time at that time.

Besides, a batch type RF plasma processing apparatus having a coil for discharging in a tubular furnace as shown in Fig. 3 (b) may be used as the plasma processing apparatus.

In Fig. 3 (b), 28 denotes a chamber, 30 denotes a heater, 32 denotes an RF power source, 34 denotes discharge electrode plates, and 36 denotes a wafer which is an object to be processed.

### ③ The third process

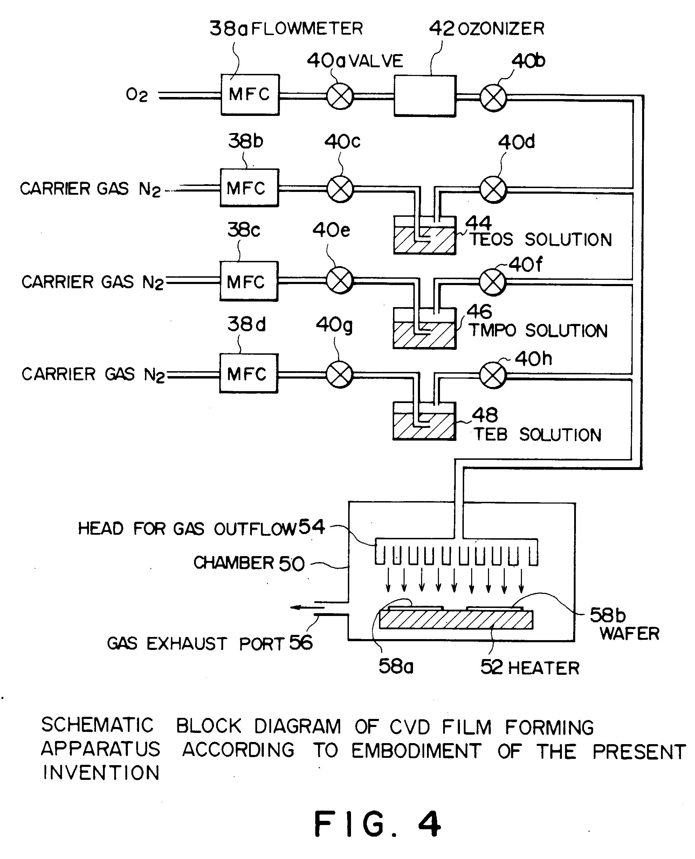

Next, a CVD-SiO₂ film by the TEOS-O₃ reaction is accumulated on a surface of a substrate reformed by plasma processing in the second process as shown in Fig. 1 (c). For example, the temperature of the substrate is set to 400°C, the TEOS source temperature is set to 65°C (saturated vapor pressure at 20 mmHg), the O₃ concentration is set to 5%, the flow rate of the carrier gas N₂ is set to 3.5 SLM and processing is performed for 7 to 8 minutes using a CVD film forming apparatus shown in Fig. 4.

With this, a SiO₂ film having the film thickness of approximately 1 µm is accumulated, but the film thickness b of the CVD-SiO₂ film formed on the thermal SiO₂ film 12 and the film thickness a of the CVD-SiO₂ film formed on the poly-Si film 14 becomes equal to each other (a = b) at that time, and the unevenness on a surface A of a CVD-SiO₂ film on the thermal SiO₂ film 12 disappears similarly to a surface B of the CVD-SiO₂ film on the poly-Si film 14, and the surface A becomes very smooth. Further, coverage of above-mentioned CVD-SiO₂ film with respect to steps on the poly-Si film was also excellent.

### (2) Extended example and experimental example of the embodiment of the present invention

### ① Another embodiment of the present invention

Fig. 4 is a schematic block diagram of a CVD film forming apparatus used in a manufacturing method according to an embodiment of the present invention. In Fig. 4, 38a to 38d denote flowmeters (MFC), 40a to 40h denote valves, 42 denotes an ozonizer which changes oxygen (O₂) into ozone (O₃), 44 denotes a TEOS solution which is set at a temperature of 40 to 65°C, 46 denotes a tri-metyl phosphate (TMPO) solution which is set at 50 to 60°C, and 48 denotes a tri-etyl borate (TEB) solution which is set at 5 to 50°C.

Further, 50 denotes a chamber, 52 denotes a heater, 54 denotes a head for effluence of gas, 56 denotes a gas exhaust port, and 58a and 58b denote wafers which become objects of film formation.

When a SiO₂ film is accumulated, the valves 40a to 40d are opened in the manufacturing apparatus shown in Fig. 4. With this, O₃ gas coming out of the ozonizer 42 and TEOS gas sent out through carrier gas N₂ are supplied into the chamber 50 from the head 54 for effluence of gas, the TEOS gas is decomposed by O₃ on the wafers 58a and 58b, and a CVD-SiO₂ film is accumulated on the surfaces of the wafers.

Besides, the O₃ concentration is changed by adjusting O₂ - O₃ transformation quantity in the ozonizer 42 or by regulating a flowmeter MFC 38a and a valve 40a or 40b.

Further, when a PSG film, a BSG film or a BPSG film and the like are accumulated other than the SiO₂ film, they may be formed selectively by opening and closing the valves 40a to 40h appropriately.

Furthermore, a CVD film by the TEOS-O₃ reaction has been described in the embodiment, but the present invention is also applicable to a film formed by the reaction between other alkoxysilane and various siloxane compound (for example, polysiloxane (Octe-Methyl-Cyclo-Tetra-Siloxiane) and the like) and O₃.

### ② Experimental example of the present invention (1)

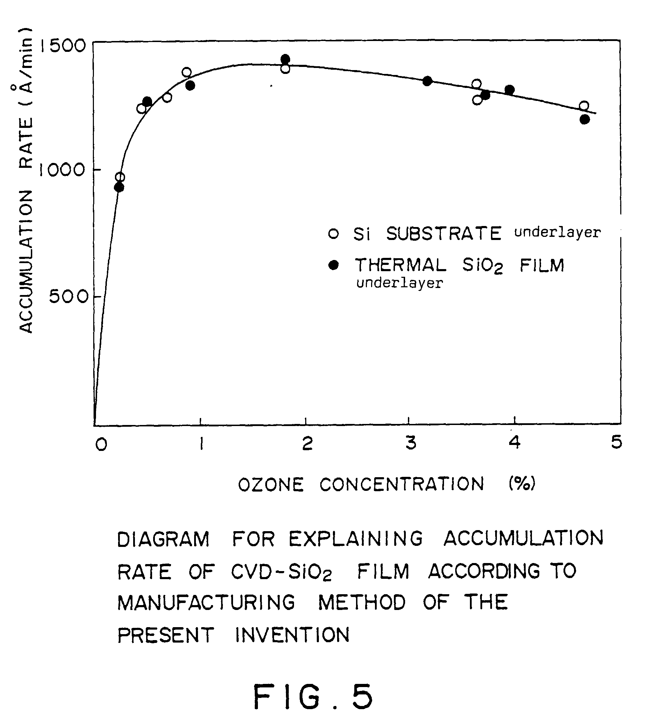

Fig. 5 is a diagram showing an accumulation rate when a SiO₂ film by the TEOS-O₃ reaction is accumulated on a Si substrate having a hydrophobic surface and an accumulation rate when a SiO₂ film by the TEOS-O₃ reaction is accumulated after the thermal SiO₂ film on a hydrophilic surface is reformed into a hydrophobic surface through plasma processing. The axis of abscissas shows the O₃ concentration, the axis of ordinate shows an accumulation rate, and accumulating conditions are such that the substrate temperature is at 400°C and the TEOS source temperature is at 65°C.

As shown in the Figure, the accumulation rate of the SiO₂ film on the thermal SiO₂ film becomes almost equal to the accumulation rate of the SiO₂ film on the Si substrate regardless of the O₃ concentration, thus making it possible to solve conventional problems (on the contrary, according to a conventional method in which plasma processing is not performed, the accumulation rate of the CVD-SiO₂ film on the thermal SiO₂ film shows a bigger difference from the accumulation rate of the CVD-SiO₂ film on the poly-Si film as the O₃ concentration gets higher (see Fig. 8).

### ③ Experimental example of the present invention (2)

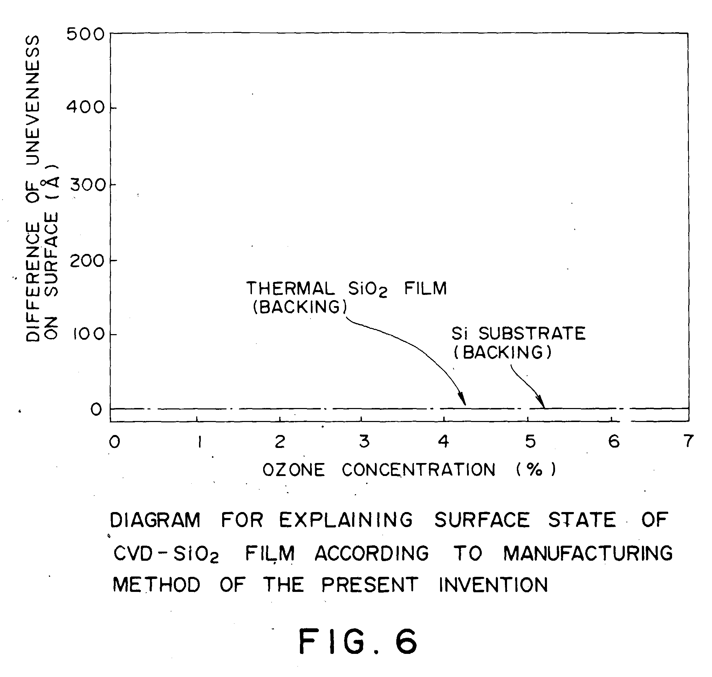

Further, Fig. 6 is a diagram showing the result of measurement of the unevenness on the surface of a SiO₂ film when the SiO₂ film by the TEOS-O₃ reaction is accumulated on a Si substrate having a hydrophobic surface and the unevenness on a surface of a SiO₂ film when the SiO₂ film by the TEOS-O₃ reaction is accumulated after the thermal SiO₂ film having a hydrophilic surface is reformed into a hydrophobic surface through plasma processing. The axis of abscissas shows the O₃ concentration, the axis of ordinate shows the accumulation rate, and the accumulation conditions are such that the substrate temperature is at 400°C and the TEOS source temperature is at 65°C.

As shown in Fig. 6, unevenness does not appear on the surface of the SiO₂ film of the CVD-SiO₂ film accumulated on the thermal SiO₂ film after plasma processing even when the O₃ concentration gets high. Naturally, unevenness does neither appear regardless of the O₃ concentration on the surface of the CVD-SiO₂ film accumulated on the poly-Si film (on the contrary, with a conventional method in which plasma processing is not performed, the unevenness on the surface of the CVD-SiO₂ film on the thermal SiO₂ film becomes more intense as the O₃ concentration is increased (see Fig. 9).

As described above, according to the embodiment of the present invention, it is possible to form a film having the same film thickness and no unevenness on the surface while obtaining a SiO₂ film of high quality by the TEOS-high concentration O₃ reaction and eliminating the influence by an underlayer film for accumulation by such a simple method that plasma processing is performed before a CVD-SiO₂ film is accumulated by a reaction containing organic silane and O₃ thereby to reform the surface of the substrate. Hence, the embodiment is very effectual when it is applied to formation of an interlayer insulating film of a semiconductor device such as a VLSI.

### ④ Experimental example of the present invention (3)

Table 1 shows the effect of a plasma processing method according to an embodiment of the present invention. The plasma processing conditions are such that processing has been performed under N₂ gas, a high frequency power source at 13.56 MHz, electric power at 200 W and a degree of vacuum at 1 Torr, and accumulation conditions of the CVD-SiO₂ film are such that accumulation has been performed under the substrate temperature at 400°C and the O₃ concentration at 5%.

The criterion of the effects has been judged by the magnitude of the difference between the accumulation rate of the CVD-SiO₂ film accumulated on the thermal SiO₂ film and the accumulation rate of the CVD-SiO₂ film accumulated on Si, and the intensity of the unevenness on the surface of the CVD-SiO₂ film. In the table, a mark o shows effectual, a mark △ shows effectual to some extent, and a mark x shows non-effectual.

**TABLE 1**

| Substrate Temperature (°C) | Processing Time (minutes) | | | | |
|---|---|---|---|---|---|
| | 1 min. | 5 min. | 10 min. | 30 min. | 60 min. |
| Room Temperature | x | x | x | x | x |
| 100°C | x | x | x | x | x |
| 150°C | x | x | x | Δ | Δ |
| 200°C | x | x | Δ | Δ | ○ |
| 250°C | Δ | Δ | ○ | ○ | ○ |
| 300°C | ○ | ○ | ○ | ○ | ○ |
| 350°C | ○ | ○ | ○ | ○ | ○ |
| 400°C | ○ | ○ | ○ | ○ | ○ |

It is realized through the experimental results that it is possible to reform the surface with processing in N₂ gas for approximately one minute when the substrate temperature is set at 350°C.

As described above, according to a manufacturing method of the present invention, it is possible to form a film having even film thickness and no unevenness on the surface on an underlayer film while obtaining a film of high quality by high concentration O₃ reaction and eliminating the influence of the underlayer film by such a simple method that plasma processing is performed before a CVD-SiO₂ film is accumulated by a reaction containing organic silane and O₃ thereby to reform the surface of the substrate. Accordingly, the present invention is very effectual when it is applied to formation of an interlayer insulating film of a semiconductor device such as a VLSI in submicron having a multi-layer structure.

## Claims

1. A manufacturing method for a semiconductor device, characterized in that
(i) a surface of a substrate is treated by high frequency plasma irradiation to convert the surface from one with hydrophilic properties to one with hydrophobic properties, and
(ii) the substrate is heated, in the presence of an organic silane and ozone, and under normal or reduced pressure, a silicon oxide film thus being formed on said substrate via CVD.

2. A manufacturing method for a semiconductor device according to claim 1, characterized in that the organic silane gas contains phosporus and/or boron impurities such that a PSG film, a BSG film or a BPSG film is formed on said substrate.

## Patentansprüche

1. Verfahren zum Herstellen einer Halbleiteranordnung, **dadurch gekennzeichnet**, daß
(i) eine Oberfläche eines Substrates durch Hochfrequenz-Plasmabestrahlung behandelt wird, um die Oberfläche von einer Fläche mit hydrophilen Eigenschaften in eine mit hydrophoben Eigenschaften umzuwandeln, und daß
(ii) das Substrat bei Anwesenheit eines organischen Silans und von Ozon bei normalem oder verringertem Druck erwärmt wird, wodurch auf dem Substrat durch CVD ein Siliziumoxid-Film ausgebildet wird.

2. Verfahren zum Herstellen einer Halbleiteranordnung nach Anspruch 1, dadurch gekennzeichnet, daß das organische Silan-Gas Phosphor- und/oder Bor-Verunreinigungen in der Weise enthält, daß ein PSG-Film, ein BSG-Film oder ein BPSG-Film auf dem Substrat ausgebildet wird.

## Revendications

1. Procédé de fabrication d'un dispositif semi-conducteur, caractérisé par le fait qu'il comprend les étapes consistant :
(i) à traiter une surface d'un substrat par irradiation plasma haute fréquence pour convertir la surface ayant des propriétés hydrophiles en une surface ayant des propriétés hydrophobes, et
(ii) à chauffer le substrat, en présence d'un silane organique et d'ozone, sous pression normale ou réduite, un film d'oxyde de silicium étant ainsi formé sur ledit substrat par CVD.

2. Procédé de fabrication d'un dispositif semi-conducteur selon la revendication 1, caractérisé par le fait que le gaz silane organique contient des impuretés de phosphore et/ou de bore de telle sorte qu'il se forme un film PSG, un film BSG ou un film BPSG sur ledit substrat.
